Europäisches Patentamt

European Patent Office

Office européen des brevets

(19)

(11) **EP 0 794 497 A2**

# (12) EUROPEAN PATENT APPLICATION

(43) Date of publication:
10.09.1997 Bulletin 1997/37

(51) Int. Cl.⁶: **G06F 13/16**

(21) Application number: 97103629.8

(22) Date of filing: 05.03.1997

(84) Designated Contracting States:
**DE FR GB NL**

(30) Priority: 08.03.1996 JP 51270/96

(71) Applicant:
**MATSUSHITA ELECTRIC INDUSTRIAL CO., LTD.**
**Kadoma-shi, Osaka-fu, 571 (JP)**

(72) Inventors:
• **Sezaki, Tomohisa**
  **Yodogawa-ku, Osaka-shi, Osaka (JP)**
• **Kakiage, Touru**
  **Neyagawa-shi, Osaka (JP)**
• **Sumida, Keizo**
  **Hirakata-shi, Osaka (JP)**
• **Suzuki, Masato**
  **Toyonaka-shi, Osaka (JP)**

(74) Representative: **Schwabe - Sandmair - Marx**
  **Stuntzstrasse 16**
  **81677 München (DE)**

(54) **Memory refresh control method and apparatus**

(57)    By a memory refresh control method for controlling timing for refreshing a memory connected to a bus, a detection section detects whether or not the bus is free within a prescribed period. When the bus is detected to be free within the prescribed period, a control section outputs a first refresh request to the memory. When the bus is detected to be never free within the prescribed period, the control section outputs a second refresh request to the memory after the prescribed period.

FIG. 1

EP 0 794 497 A2

## Description

### BACKGROUND OF THE INVENTION

#### 1. FIELD OF THE INVENTION:

The present invention relates to a memory refresh control method used for a DRAM (dynamic random access memory) which requires a refresh operation to be performed a prescribed number of times within a prescribed time period, and an apparatus for carrying out such a method.

#### 2. DESCRIPTION OF THE RELATED ART:

A DRAM is a memory device for storing information in accordance with the amount of charge accumulated in a microscopic capacitor in a memory cell, and thus loses information over time. Accordingly, reading and rewriting of information which has been stored in the DRAM, namely, a refresh operation needs to be performed at a certain time interval. The refresh operation, which is performed using a common bus connected to the DRAM, cannot be conducted simultaneously with other operations which also require access to the common bus such as, for example, information reading from the DRAM and information writing to the DRAM by the CPU (central processing unit) or peripheral devices. Accordingly, arbitration is required between a bus access request for the refresh operation and bus access requests to the common bus for other operations.

According to one known method for controlling the timing for refreshing the DRAM, all the memory cells in the DRAM are refreshed by performing a refresh operation a prescribed number of times within a prescribed time period at a constant interval. Under this method, a refresh operation is performed, for example, every 15.625 microseconds with certainty. When a bus access request for the refresh operation and other bus access requests are made simultaneously, the bus access request for the refresh operation is given priority and other bus access requests are temporarily rejected.

It is desirable that the refresh operation of the DRAM be performed while avoiding, as much as possible, interrupting other operations requiring access to the common bus (e.g., information reading from the DRAM and information writing to the DRAM by the CPU or other devices) or putting such operations into a waiting state for access to the common bus.

By the conventional refresh control method, when a bus access request for the refresh operation and other bus access requests are made simultaneously, the bus access request for the refresh operation needs to be given priority and the other bus access requests are not accepted. Accordingly, the operations other than the refresh operation are interrupted or put into a waiting state for bus access, resulting in reduction in utilization efficiency of the bus. Furthermore, the wait time for the bus access caused by the refresh operation cannot be ignored due to improvements in processing rates of CPUs.

### SUMMARY OF THE INVENTION

According to one aspect of the invention, a memory refresh control method for controlling timing for refreshing a memory connected to a bus includes the steps of: detecting whether or not the bus is free within a prescribed period; outputting a first refresh request to the memory when the bus is detected to be free within the prescribed period; and outputting a second refresh request to the memory after the prescribed period, when the bus is detected to be never free within the prescribed period.

In this specification, the term "free" refers to the state in which there is no bus access request.

In one embodiment of the invention, the prescribed period has a duration of Tr/Nr or less when the memory requires a refresh operation to be executed at least Nr times within a period Tr.

In another embodiment of the invention, the second refresh request is output in a prescribed period succeeding the prescribed period where the bus is detected to be never free.

In still another embodiment of the invention, the first refresh request and the second refresh request are each output at most once within the prescribed period.

According to another aspect of the invention, a memory refresh control apparatus for controlling timing of refreshing a memory connected to a bus includes: a detection section for detecting whether or not the bus is free within a first period; and a control section for outputting a first refresh request to the memory when the bus is detected to be free within the first period, and outputting a second refresh request to the memory after the first period, when the bus is detected to be never free within the first period.

In one embodiment of the invention, the control section outputs the second refresh request in a second period succeeding the first period where the bus is detected to be never free.

In another embodiment of the invention, the memory refresh control apparatus further includes: a first flag generation section for generating a first flag which is set when the first refresh request needs to be output; and a second flag generation section for generating a second flag which is set when the second refresh request needs to be output. The control section outputs the first refresh request when the first flag is set and the detection section detects that the bus is free, and outputs the second refresh request when the second flag

In still another embodiment of the invention, the first flag is set when the first period passes, and the second flag is set when the first period passes while the first flag is set.

In yet another embodiment of the invention, the first flag is reset when the first refresh request is output, and the second flag is reset when the second refresh request is output.

According to the refresh control method and apparatus of the present invention, the refresh control operation is executed in the following manner.

When the bus is detected to be free in a prescribed period, the bus is occupied for the refresh operation, and the refresh operation is executed. When the bus is detected not to be free in a prescribed period, the device which is occupying the bus is allowed to continue occupying the bus. At this point, the operation performed by the device is not stopped. If the bus is still occupied after the prescribed period, the bus is forcibly occupied for the refresh operation, and the refresh operation is executed. Due to such a system, the requirements of the DRAM regarding the refresh operation are fulfilled, and the frequency by which the operations other than the refresh operation are interrupted or put into a state of waiting for the bus access is reduced.

Thus, the invention described herein makes possible the advantages of providing a memory refresh control method for executing a refresh operation of a DRAM connected to a common bus while avoiding, as much as possible, interrupting other operations requiring access to the common bus or putting such operations into a waiting state for access to the common bus, and an apparatus for carrying out such a method.

These and other advantages of the present invention will become apparent to those skilled in the art upon reading and understanding the following detailed description with reference to the accompanying figures.

BRIEF DESCRIPTION OF THE DRAWINGS

Figure 1 is a block diagram of an information processing apparatus including a DRAM refresh controller according to the present invention;

Figure 2 shows a flow of operations for generating a refresh count flag output performed by a refresh count flag generator in the DRAM refresh controller shown in Figure 1;

Figure 3 shows a flow of operations for generating a refresh count overflow flag output performed by a refresh count overflow flag generator in the DRAM refresh controller shown in Figure 1;

Figure 4 shows a flow of operations for bus arbitration and for controlling the timing of refresh operation performed by an arbiter in the DRAM refresh controller shown in Figure 1; and

Figure 5 is a timing diagram showing the operation of the DRAM refresh controller shown in Figure 1.

DESCRIPTION OF THE PREFERRED EMBODIMENTS

Hereinafter, the present invention will be described by way of illustrative, but non-limiting, examples with reference to the accompanying drawings.

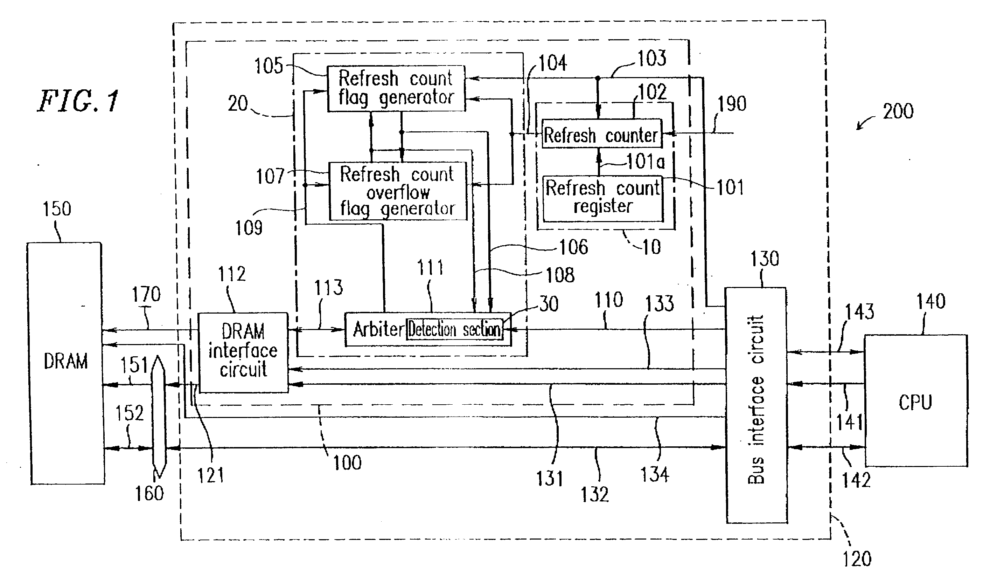

Figure 1 is a block diagram of an information processing apparatus 200 including a DRAM refresh controller 100 according to the present invention. The information processing apparatus 200 includes a CPU 140, a bus controller 120, a DRAM 150 and a common bus 160. The bus controller 120 includes the DRAM refresh controller 100 and a bus interface circuit 130. The CPU 140 is connected to the bus interface circuit 130 in the bus controller 120 via address lines 141, data lines 142 and control signal lines 143. The bus controller 120 is connected to the common bus 160 via address lines 121 and data lines 132. The DRAM 150 is connected to the common bus 160 via address lines 151 and data lines 152. DRAM control signals 170 output from the bus controller 120 and a read/write signal 134 are input to the DRAM 150.

The CPU 140 processes arithmetic operations, and manages and controls the processing of the entire information processing apparatus 200. The CPU 140 writes information into the DRAM 150 and reads information stored in the DRAM 150 via the bus controller 120. The CPU 140 outputs a bus access request to the bus controller 120 via the control signal lines 143 when the CPU 140 needs access to the DRAM 150. The bus access request is output from the CPU 140 and other devices (not shown) such as a DMA (direct memory access) controller. A bus access request for a DRAM refresh operation is generated in the bus controller 120.

The bus controller 120 arbitrates these bus access requests and determines one device which is permitted to occupy the common bus 160. In this specification, the device which occupies and uses the common bus 160 at a certain time point is referred to as a "bus master", and determining the bus master is referred to as "bus arbitration". The operation of the DRAM 150 is controlled by the DRAM control signals 170 output from the bus controller 120 and the read/write signal 134. The refresh operation of the DRAM 150 is executed by a refresh request carried by the DRAM control signal 170 from the bus controller 120.

The DRAM refresh controller 100 controls the timing of refreshing the DRAM 150 and executes the refresh operation. The DRAM refresh controller 100 includes a counting section 10 for counting a prescribed time period. The counting section 10 includes a refresh count register 101 and a refresh counter 102. The refresh count register 101 stores the number of clock cycles corresponding to a prescribed time period which is set for controlling the timing of refreshing the DRAM 150. In this specification, the prescribed time period set for controlling the timing of refreshing a DRAM will be referred to as a "refresh count period". The refresh counter 102 receives an output 101a from the refresh count register 101, a clock signal 190 and a refresh enable signal 103. The clock signal 190 is used as a reference for various operations performed in the entire information processing apparatus 200, and is input from outside the bus controller 120. The clock signal may be generated within the bus controller 120. The refresh enable signal 103 is asserted for putting the refresh operation into an enable state, and is output from the bus interface circuit 130 by an instruction sent from the CPU 140 to a register (not shown) in the bus interface circuit 130. The refresh counter 102 counts the refresh count period by counting the number of clock cycles stared in the refresh count register 101. The refresh counter 102 asserts a refresh count overflow output 104 when the number of the clock cycles of the clock signal 190 counted by the refresh counter 102 equals the number of clock cycles stored in the refresh count register 101.

The DRAM refresh controller 100 further includes a control section 20. The control section 20 includes a refresh count flag generator 105 (first flag generation section) and a refresh count overflow flag generator 107 (second flag generation section). The refresh count flag generator 105 receives the refresh count overflow output 104, the refresh enable signal 103, a refresh count overflow flag output 108 and a refresh acknowledge output 109. The refresh count flag generator 105 generates a refresh count flag based on the signals received and outputs a refresh count flag output 106 based on the state of the refresh count flag. An assertion of the refresh count flag output 106 indicates that a refresh operation is required when the common bus 160 is free with no bus access request except for a bus access request for the refresh operation within a refresh count period. In this specification, the term "free" refers to the state in which there is no bus access request. The refresh count overflow flag generator 107 receives the refresh count overflow output 104, the refresh count flag output 106, and the refresh acknowledge output 109. The refresh count overflow flag generator 107 generates a refresh count overflow flag based on the signals received and outputs the refresh count overflow flag output 108 based on the state of the refresh count overflow flag. An assertion of the refresh count overflow flag output 108 indicates that the common bus 160 was never free during a refresh count period and thus forcible execution of a refresh operation is required during the next refresh count period.

The refresh acknowledge output 109 indicates that a refresh operation has been executed, and is output from an arbiter 111 described below.

The control section 20 further includes the arbiter 111. The arbiter 111 receives a bus request signal 110, the refresh count flag output 106 and the refresh count overflow flag output 108, and outputs the refresh acknowledge output 109. The bus request signal 110 is asserted when a bus access request is made by the CPU 140 or a DMA controller (not shown). Other devices may also make a bus access request for purposes other than the DRAM refresh operation. In the following description, bus access requests for purposes other than the DRAM refresh operation are made by the CPU 140, for example. The arbiter 111 includes a detection section 30, to which bus request signal 110 is sent. The detection section 30 determines whether or not there is a request for occupying the common bus 160 for purposes other than the DRAM refresh operation based on the bus request signal 110, and detects if the common bus 160 is free or not. The detection section 30 is included in the control section 20 in this example, but may be provided outside the control section 20. The arbiter 111 determines the bus master based on the detection result of the detection section 30, the refresh count flag output 106, and the refresh count overflow flag output 108. When the arbiter 111 determines that a refresh operation is required, the arbiter 111 outputs a refresh request signal as a DRAM interface control signal 113 to a DRAM interface circuit 112 described below.

The refresh count flag generator 105, the refresh count overflow flag generator 107, and the arbiter 111 are included in the control section 20 as described above. The control section 20 controls the common bus so as to be in one of the two states, i.e., a first state in which the common bus 160 is occupied for the DRAM refresh operation, and a second state in which the common bus 160 is occupied for any other purpose.

The DRAM refresh controller 100 further includes the DRAM interface circuit 112. The DRAM interface circuit 112 receives an address via address lines 131 and receives a control signal 133 from the bus interface circuit 130, and outputs the address via the address lines 121 and the DRAM control signals 170. The DRAM control signals 170 include, for example, a CAS control signal indicating that a column address is instructed to the DRAM 150 or a RAS control signal indicating that a row address is instructed to the DRAM 150. The DRAM interface circuit 112 generates an address based on the address received via the address lines 131 and information which specifies the width of the address and is included in the control signal 133, and outputs the result as the address via the address lines 121. The address is sent to the DRAM 150 through the common bus 160. The DRAM interface control signal 113 is sent between the arbiter 111 and the DRAM interface circuit 112. When the arbiter 111 determines the common bus 160 is used for the refresh control of the DRAM 150, the DRAM interface circuit 112 receives a refresh request sent from the arbiter 111 as the DRAM interface control signal 113. When the DRAM interface circuit 112 accepts the refresh request, the DRAM interface circuit 112 outputs a refresh acknowledge signal also as the DRAM interface control signal 113 to the arbiter 111. The refresh acknowledge signal indicates that the refresh request has been accepted. When the arbiter 111 determines that the common bus 160 is used for access by the CPU 140 to the DRAM 150, the arbiter 111 outputs a DRAM access request signal in the form of the DRAM interface control signal 113 to the DRAM interface circuit 112. When the DRAM interface circuit 112 accepts the DRAM access request, the DRAM interface circuit 112 outputs a DRAM access acknowledge signal also in the form of the DRAM interface control signal 113 to the arbiter 111. The DRAM access acknowledge signal indicates that the DRAM access request has been accepted.

In this specification, the refresh enable signal 103, the refresh count overflow output 104, the refresh count flag output 106, the refresh count flag overflow output 108, and refresh acknowledge output 109, and the bus request signal 110 are all active-high signals which are asserted when being high.

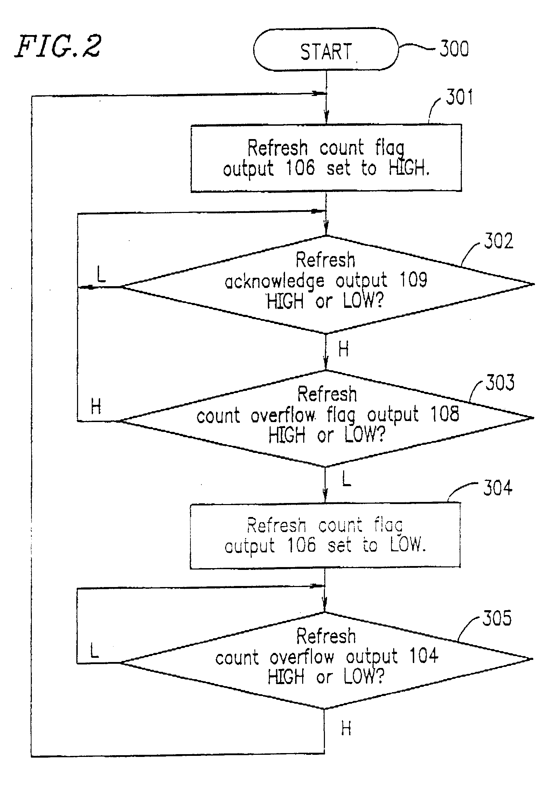

With reference to Figures 2 through 5, the operation of the DRAM refresh controller 100 will be described.

Figure 2 shows the flow of operations for generating the refresh count flag output 106 performed by the refresh count flag generator 105. The refresh count flag generator 105 puts the refresh count flag output 106 into a high state when the refresh count flag is in a set state and puts the refresh count flag output 106 into a low state when the refresh count flag is in a reset state. Figure 2 shows the conditions for causing the refresh count flag output 106 to transit between the high state and the low state, and the operations performed in accordance with the conditions.

In step 300, the refresh count flag generator 105 starts the below described operations for generating the refresh count flag output 106.

In step 301, when the refresh enable state is realized by the refresh enable signal 103 based on an instruction from the CPU 140, the refresh count flag generator 105 sets the refresh count flag and puts the refresh count flag output 106 into a high state. When the refresh count flag output 106 is high, a refresh operation is required while the common bus 160 is free within the refresh count period. Thus, the operation proceeds to step 302.

In step 302, the refresh count flag generator 105 examines the refresh acknowledge output 109. If the refresh acknowledge output 109 is in a low state, the refresh operation has not been executed. Thus, the operation in step 302 is repeated. If the refresh acknowledge output 109 is in a high state, the refresh request has been accepted and the refresh operation has been executed. The operation proceeds to step 303.

In step 303, the refresh count flag generator 105 examines the refresh count overflow flag output 108. If the refresh count overflow flag output 108 is in a high state, the refresh operation was executed after the refresh counter 102 was overflown (i.e., after the refresh count period passed). Thus, the operation goes back to step 302 and the operations in steps 302 and 303 are repeated. If the refresh count overflow flag output 108 is in a low state, the refresh operation was executed before the refresh counter 102 was overflown (i.e., within the refresh count period), and the operation moves to step 304.

In step 304, the refresh count flag generator 105 resets the refresh count flag and puts the refresh count flag output 106 into a low state. Then, the operation goes to step 305. When the refresh count flag output 106 is low, the refresh operation has already been executed and thus no more refresh operation is required even if the common bus 160 is free within the rest of the refresh count period.

In step 305, the refresh count flag generator 105 examines the refresh count overflow output 104. If the refresh count overflow output 104 is in a low state, the present time is in the rest of the refresh count period after the refresh operation was executed and no more refresh operation is required. Thus, the operation in step 305 is repeated. If the refresh count overflow output 104 is in a high state, the next refresh count period starts. Thus, the operation returns to step 301. Thereafter, the operations in steps 301 through 305 are repeated.

The state transition of the refresh count flag output 106 can be summarized as follows.

The refresh count flag output 106 becomes high when a refresh count period has passed, i.e., when the refresh count overflow output 104 is asserted. The refresh count flag output 106 becomes low when a refresh operation has been executed while the common bus 160 is free within a refresh count period, i.e., when the refresh acknowledge output 109 is asserted while the refresh count overflow flag output 108 is low.

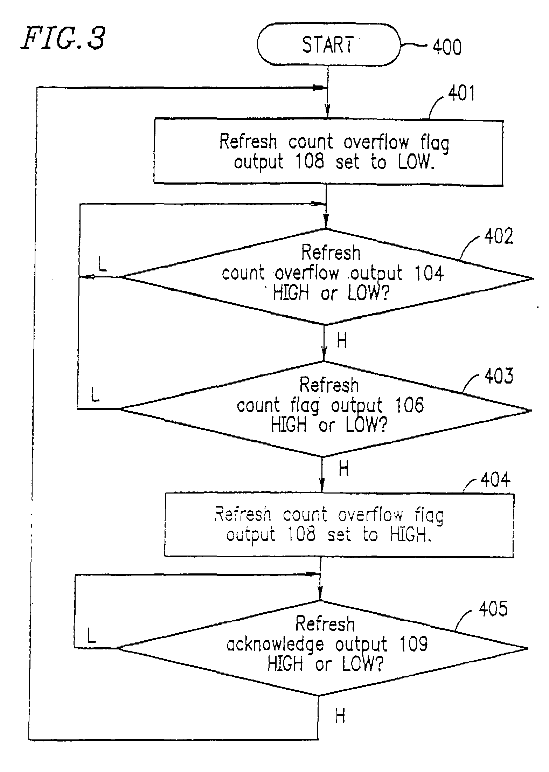

Figure 3 shows a flow of operations for generating the refresh count overflow flag output 108 performed by the refresh count overflow flag generator 107. The refresh count overflow flag generator 107 puts the refresh count overflow flag output 108 into a high state when the refresh count overflow flag is in a set state and puts the refresh count overflow flag output 108 into a low state when the refresh count overflow flag is in a reset state. Figure 3 shows the conditions for causing the refresh count overflow flag output 108 to transit between the high state and the low state, and the operations performed in accordance with the conditions.

In step 400, the refresh count overflow flag generator 107 starts the below described operations for generating the refresh count overflow flag output 108.

In step 401, when the refresh enable state is realized and the refresh count flag output 106 becomes high, the refresh count overflow flag generator 107 resets the refresh count overflow flag and puts the refresh count overflow flag output 108 into a low state. When the refresh count overflow flag output 108 is low, forcible execution of the refresh operation is not required. The operation then goes to step 402.

In step 402, the refresh count overflow flag generator 107 examines the refresh count overflow output 104. If the refresh count overflow output 104 is in a low state, the refresh counter 102 has not been overflown yet. Thus, the operation in step 402 is repeated. If the refresh count overflow output 104 is in a high state, the refresh counter 102 has overflown, i.e., the refresh count period has passed, and the operation goes to step 403.

In step 403, the refresh count overflow flag generator 107 examines the refresh count flag output 106. If the refresh count flag output 106 is in a low state, the refresh operation was executed before the refresh counter 102 was overflown (i.e., within the refresh count period). Thus, the operation goes back to step 402 and the operations in stops 402 and 403 are repeated. If the refresh count flag output 106 is in a high state, the refresh operation has not been executed even after the refresh counter 102 overflew (i.e., after the refresh count period passed), and thus the operation proceeds to step 404.

In step 404, the refresh count overflow flag generator 107 sets the refresh count overflow flag and puts the refresh count overflow flag output 108 into a high state. Then, the operation goes to step 405. When the refresh count overflow flag output 108 is high, the common bus 160 was not free in a refresh count period. Thus, forcible execution of the refresh operation is required during the next refresh count period.

In step 405, the refresh count overflow flag generator 107 examines the refresh acknowledge output 109. If the refresh acknowledge output 109 is in a low state, the refresh operation has not been executed. Thus, the operation in step 405 is repeated. If the refresh acknowledge output 109 is in a high state, the refresh operation has been executed. Thus, the operation goes back to step 401. Thereafter, the operations in steps 401 through 405 are repeated.

The state transition of the refresh count overflow flag output 108 can be summarized as follows.

The refresh count overflow flag output 108 becomes high when a refresh count overflow output 104 is asserted (i.e., the refresh count period has passed) while the refresh count flag output 106 was high. The refresh count overflow flag output 108 becomes low when a refresh operation has been executed, i.e., when the refresh acknowledge output 109 is asserted.

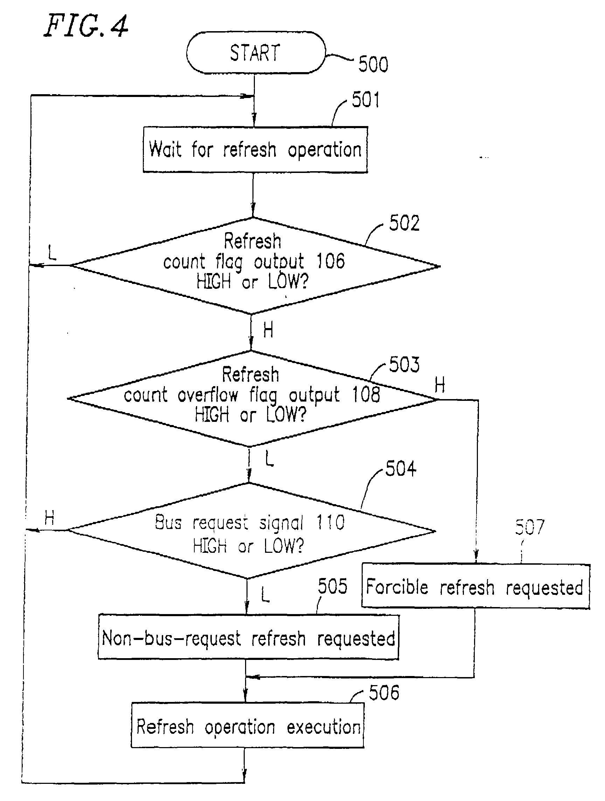

Figure 4 shows a flow of operations for bus arbitration and for controlling the timing of the refresh operation. The arbiter 111 performs bus arbitration based on the refresh count flag output 106, the refresh count overflow flag output 108, and the bus request signal 110. Figure 4 shows the conditions for causing the common bus 160 to transit between the wait state for the refresh operation (i.e., the state in which the common bus 160 is being accessed by another device) and the refresh operation execution state, and the operations performed in accordance with the conditions.

In step 500, the arbiter 111 starts the operations for bus arbitration and for controlling the timing of the refresh operation.

In step 501, the arbiter 111 is in the wait state for the refresh operation. The arbiter 111 is in this state either when the common bus 160 is occupied for a bus access for operations other than the refresh operation or when a refresh operation has been executed and the common bus 160 is waiting for the start of the next refresh count period. The operation proceeds to step 502.

In step 502, the arbiter 111 examines the refresh count flag output 106. As described above, the refresh count flag indicates whether or not a refresh operation is required when the common bus 160 is free with no other bus access request. Hereinafter, the state in which the common bus 160 is free with no bus access request for operations other than the refresh operation in a refresh count period will be referred to as a "non-bus-request state", and a refresh operation in the non-bus-request state will be referred to as a "non-bus-request refresh operation (first refresh operation)".

If a non-bus-request refresh operation has been executed, the refresh count flag output 106 is in a low state. The operation goes back to step 501 and the operations in steps 501 and 502 are repeated until the refresh count flag output 106 becomes high. If there is a bus access request for operations other than the refresh operation during this time period, the arbiter 111 accepts the bus access request.

If a non-bus-request refresh operation has not been executed, the refresh count flag output 106 is in a high state, and the operation goes to step 503.

In step 503, the arbiter 111 examines the refresh count overflow flag output 108. If the refresh count overflow flag output 108 is in a high state, the non-bus-request refresh operation was not executed within the refresh count period and forcible execution of the refresh operation is required. Thus, the operation goes to step 507. If the refresh count overflow flag output 108 is in a low state, forcible execution of the refresh operation is not required, and the operation moves to step 504.

In step 504, the arbiter 111 examines whether or not there is a bus access request for operations other than the refresh operation based on the bus request signal 110. If the bus request signal 110 is in a high state indicating that there is another bus access request, the operation returns to step 501, namely, the wait state for the refresh operation, and the operations in steps 501 through 504 are repeated. If the bus request signal 110 is in a low state indicating the common bus 160 is free with no other bus access request, the operation goes to step 505.

In step 505, the arbiter 111 generates a request for a non-bus-request refresh operation (first refresh request) internally. Since it is found in step 504 that the common bus 160 is free, the operation goes to step 506 for executing the refresh operation.

In step 507, the arbiter 111 generates a request for a forcible refresh operation (second refresh request) internally and causes the common bus 160 to be occupied by the refresh operation. Then, the operation proceeds to step 506 for executing the refresh operation.

In step 506, the arbiter 111 is in the refresh operation execution state. The arbiter 111 outputs a refresh request signal as the DRAM interface control signal 113 to the DRAM interface circuit 112 based on the first refresh request or the second refresh request generated in the arbiter 111. The DRAM interface circuit 112 sends a refresh acknowledge signal also as the DRAM interface control signal 113 to the arbiter 111 and sends a refresh request to the DRAM 150. As described above, the refresh acknowledge signal indicates that the refresh request has been accepted.

After the refresh operation, the arbiter 111 goes back to step 501, namely, the wait state for the refresh operation, and then the above-described operations are repeated.

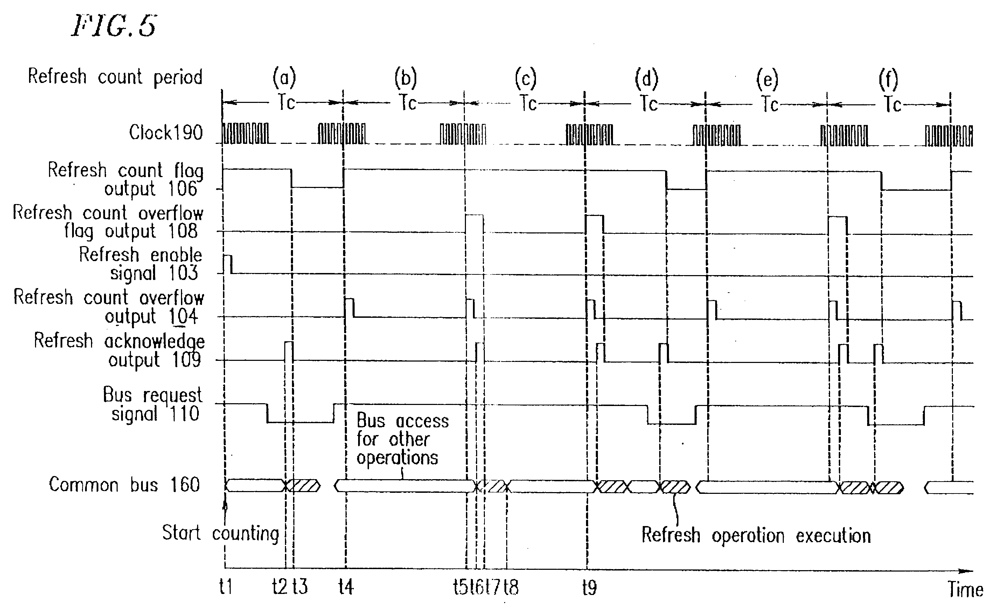

Figure 5 is a timing diagram showing the operation of the DRAM refresh controller 100. Figure 5 shows the state of the clock signal 190, the refresh count flag output 106, the refresh count overflow flag output 108, the refresh enable signal 103, the refresh count overflow output 104, the refresh acknowledge output 109, the bus request signal 110, and the common bus 160 from top to bottom. An example of the operation of the DRAM refresh controller 100 in refresh count periods (a) through (f) will be described with respect to passage of time.

(Pre-processing)

By the instruction of the CPU 140, the DRAM refresh controller 100 sets a value determined based on the refresh count period in the refresh count register 101.

The refresh count period is defined as a time period obtained by multiplying the number of clock cycles set in the refresh count register 101 by the clock cycle time. By the DRAM refresh control method used in this example, all the memory cells in the DRAM 150 are refreshed by executing a refresh operation a prescribed number of times within a prescribed time period. Hereinafter, such a prescribed time period will be referred to as the "refresh period", and the prescribed number of times will be referred to as the "refresh number". In the case where the DRAM 150 requires the refresh number Nr and the refresh period Tr, the refresh count period needs to be set to have duration Tc determined by:

$$Tc \leq Tr/Nr.$$

By executing the refresh operation within the refresh period Tr by the number of times equal to or more than in the case where a refresh operation is executed once within a refresh count period, the refresh operation is executed Nr times or more within the refresh period Tr. In this manner, the requirements of the DRAM 150 regarding the refresh operation can be fulfilled sufficiently. The DRAM refresh control method according to the present invention is carried out using a refresh count period as a unit.

(Time t1)

By instruction from the CPU 140, the refresh enable signal 103 is asserted, thereby enabling the DRAM refresh controller 100, and simultaneously, the refresh counter 102 starts counting the number of clock cycles. The refresh count flag generator 105 puts the refresh count flag output 106 into a high state, thus indicating the first refresh operation is required (step 301). The refresh count overflow flag generator 107 puts the refresh count overflow flag output 108 into a low state (step 401). Since the bus request signal 110 is in a high state, the arbiter 111 accepts the bus access request for the common bus 160 from the CPU 140 and permits bus access by the CPU 140.

(Time t2)

The bus access to the common bus 160 by the CPU 140 is terminated, and the bus request signal 110 becomes low. The detection section 30 detects that the common bus 160 is free. Accordingly, the arbiter 111 occupies the common bus 160 for the refresh operation and outputs a refresh request. Upon receiving the refresh acknowledge signal from the DRAM interface circuit 112, the arbiter 111 puts the refresh acknowledge output 109 into a high state. The DRAM interface circuit 112 executes the refresh operation of the DRAM 150. Regarding the bar indicating the state of the common bus 160 in Figure 5, hatched parts show the common bus 160 is occupied by the refresh operation of the DRAM 150 and the blank parts show the common bus 160 is occupied by the CPU 140 for a bus access for operations other than the refresh operation.

(Time t3)

Since the refresh acknowledge output 109 became high at time t2, the refresh count flag generator 105 puts the refresh count flag output 106 into a low state at time t3 (steps 302, 303 and 304). The arbiter 111 puts the refresh acknowledge output 109 back into a low state.

(Time t4)

The refresh counter 102 counts the number of clock cycles set in advance in the refresh count register 101. At time t4, when the refresh count period (a) having duration Tc passes, the refresh counter 102 puts the refresh count overflow output 104 into a high state. The refresh count flag output 106 has been low. Due to the high state of the refresh count overflow output 104 and the low state of the refresh count flag output 106, the refresh count overflow flag generator 107 maintains the refresh count overflow flag output 108 low (steps 402 and 403). When the refresh count overflow output 104 becomes high, the refresh count flag generator 105 puts the refresh count flag output 106 into a high state (steps 305 and 301). Until time t4, namely, within the refresh count period (a), the common bus 160 becomes free with no other bus access request. Therefore, the refresh operation is given a right for using the common bus 160, and a non-bus-request refresh operation is executed once. After the refresh operation, the bus request signal 110 becomes high again to cause the CPU 140 to occupy the common bus 160.

(Time t5)

The refresh counter 102 counts the number of clock cycles set in advance in the refresh count register 101. At time t5, when the refresh count period (b) having duration Tc passes, the refresh counter 102 puts the refresh count overflow output 104 into a high state. The refresh count flag output 106 is high. Accordingly, since the refresh count overflow output 104 becomes high, the refresh count overflow flag generator 107 puts the refresh count overflow flag output 108 into a high state (steps 402, 403 and 404). In the refresh count period (b), bus access requests from the CPU 140 are continued and the common bus 160 is never free. Accordingly, the refresh operation is not given a right for using the common bus 160 and no refresh operation is executed. Therefore, the refresh count overflow flag output 108 becomes high to indicate forcible execution of the refresh operation is required.

(Time t6)

The common bus 160 was never free during the refresh count period (b). Accordingly, at time t6, the arbiter 111 forcibly stops the CPU 140 from occupying the common bus 160 even if the bus request signal 110 is high, and occupies the common bus 160 for the refresh operation. Then, the refresh operation is executed. The arbiter 111 receives the refresh acknowledge signal from the DRAM interface circuit 112 and puts the refresh acknowledge output 109 into a high state.

(Time t7)

Since the refresh acknowledge output 109 became high at time t6, the refresh count overflow flag generator 107 puts the refresh count overflow flag output 108 into a low state (steps 405 and 401) at time t7. The refresh count flag generator 105 maintains the refresh count flag output 106 high because the refresh count overflow flag output 108 has been high until time t7 and also because the refresh acknowledge output 109 becomes low at time t7 (steps 302 and 303).

(Time t8)

The arbiter 111 is informed by the DRAM interface circuit 112 that the refresh operation which has been forcibly executed has been terminated. Then, the arbiter 111 permits the CPU 140 to occupy the common bus 160 and resume the bus access which was interrupted despite the high state of the bus request signal 110.

(Time t9)

The refresh counter 102 counts the number of clock cycles set in advance in the refresh count register 101. At time t9, when the refresh count period (c) having duration Tc passes, the refresh counter 102 puts the refresh count overflow output 104 into a high state. The refresh count flag output 106 is high. Accordingly, since the refresh count overflow output 104 becomes high, the refresh count overflow flag generator 107 puts the refresh count overflow flag output 108 into a high state (steps 402, 403 and 404). In the refresh count period (c), the refresh operation was forcibly executed because the common bus was never free in the refresh count period (b) due to continuous bus access requests from the CPU 140. After forcible execution of the refresh operation was completed, bus access requests were again continued until the end of the refresh count period (c). Accordingly, the refresh operation was not given a right to use the common bus 160, and thus a non-bus-request refresh operation was not executed during the refresh count period (c).

(Refresh count period (d))

Accordingly, the arbiter 111 again forcibly occupies the common bus 160 for the refresh operation. After that, the common bus 160 becomes free with no bus access request from the CPU 140. The arbiter 111 occupies the common bus 160 for executing the refresh operation again. The refresh acknowledge output 109 becomes high due to the second refresh operation in the refresh count period (d) (non-bus-request refresh operation). Accordingly, the refresh count flag generator 105 puts the refresh count flag output 106 into a low state (steps 302, 303 and 304).

(Refresh count period (e))

Bus access requests from the CPU 140 are continued and the common bus 160 is never free. Accordingly, the refresh operation is not given a right for using the common bus 160 and no refresh operation is executed as in the refresh count period (b).

(Refresh count period (f))

The common bus 160 was never free within the refresh count period (e). Accordingly, the arbiter 111 forcibly occupies the common bus 160 and executes the refresh operation. After that, the common bus 160 becomes free with no bus access request from the CPU 140. The arbiter 111 occupies the common bus 160 for executing the refresh operation again as in the refresh count period (d).

According to the present invention, the frequency by which the bus access from the CPU 140 is stopped is reduced. Furthermore, the refresh operation is executed by the same number of times as the case where the refresh operation is executed once within one refresh count period, thus fulfilling the requirements of the DRAM regarding the refresh operation.

The non-bus-request refresh operation is executed once within the prescribed refresh count period having duration Tc in the above example. Alternatively, the non-bus-request refresh operation may be executed a plurality of times if the common bus 160 becomes free a plurality of times during the rest of the refresh count period after the non-bus-request refresh operation is executed once.

In the above example, when the common bus 160 is never free for the refresh operation during a refresh count period, the refresh operation is forcibly executed in the next refresh count period. The timing for forcibly executing the refresh operation is not limited to the above-described timing. The refresh operation may be forcibly executed a plurality of refresh count periods later in lieu of the next refresh count period as long as the requirements of the DRAM with respect to the refresh operation are fulfilled.

The bus access requests are made by the CPU 140 in the above example, but various other devices may make bus access requests.

In the above example, the refresh counter 102 continues counting while the non-bus-request refresh operation is being executed. Alternatively, the refresh counter 102 may be reset at the start of the non-bus-request refresh operation and resume counting so that another refresh count period starts from that point.

In the above example, the refresh count overflow output 104 is asserted when the refresh counter 102, which counts up the number of clock cycles, reaches the value set in the refresh count register 101. Alternatively, the refresh count overflow output 104 may be asserted when the refresh counter 102, which counts down the number of clock cycles from the value set in the refresh count register 101, reaches zero.

In the above example, the refresh enable signal 103, the refresh count overflow output 104, the refresh count flag output 106, the refresh count flag overflow output 108, the refresh acknowledge output 109, and the bus request signal 110 are all active-high signals which are asserted when being high. Alternatively, these signals may be active-low signals which are asserted when being low.

In the above example, only one bus request signal 110 indicating a bus access request is input to the arbiter 111. The present invention is applicable to a structure in which a plurality of bus access request signals are input to the arbiter 111.

According to the present invention, as described above, the timing of refreshing the DRAM connected to the bus is controlled as follows.

When the common bus is detected to be free in a prescribed refresh count period, the common bus is occupied for the refresh operation. When the common bus is detected not to be free in the prescribed refresh count period, the device using the common bus is permitted to continue occupying the common bus without stopping its operation. Due to such a system, the frequency by which the operations other than the refresh operation are interrupted or put into a state of waiting for the bus access is reduced.

When the bus access requests are continuous and the common bus is never free in a prescribed refresh count period, the common bus is forcibly occupied for the refresh operation after the prescribed refresh count period. By such an operation, the requirements of the DRAM regarding the refresh operation are fulfilled.

According to the DRAM refresh control method and apparatus according to the present invention, the requirements of the DRAM regarding the refresh operation are sufficiently fulfilled while the frequency by which the operations other than the refresh operation are interrupted or put into a state of waiting for the bus access is reduced. As a result, the DRAM connected to the bus can be sufficiently refreshed while significantly improving the utilization efficiency of the bus.

Various other modifications will be apparent to and can be readily made by those skilled in the art without departing from the scope and spirit of this invention. Accordingly, it is not intended that the scope of the claims appended hereto be limited to the description as set forth herein, but rather that the claims be broadly construed.

## Claims

1.  A memory refresh control method for controlling timing for refreshing a memory connected to a bus, the method comprising the steps of:

    detecting whether or not the bus is free within a prescribed period;
    outputting a first refresh request to the memory when the bus is detected to be free within the prescribed period; and
    outputting a second refresh request to the memory after the prescribed period, when the bus is detected to be never free within the prescribed period.

2.  A memory refresh control method according to claim 1, wherein the prescribed period has a duration of Tr/Nr or less when the memory requires a refresh operation to be executed at least Nr times within a period Tr.

3.  A memory refresh control method according to claim 1, wherein the second refresh request is output in a prescribed period succeeding the prescribed period where the bus is detected to be never free.

4.  A memory refresh control method according to claim 1, wherein the first refresh request and the second refresh request are each output at most once within the prescribed period.

5. A memory refresh control apparatus for controlling timing of refreshing a memory connected to a bus, the apparatus comprising:

a detection section for detecting whether or not the bus is free within a first period; and
a control section for outputting a first refresh request to the memory when the bus is detected to be free within the first period, and outputting a second refresh request to the memory after the first period, when the bus is detected to be never free within the first period.

6. A memory refresh control apparatus according to claim 5, wherein the control section outputs the second refresh request in a second period succeeding the first period where the bus is detected to be never free.

7. A memory refresh control apparatus according to claim 5, further comprising:

a first flag generation section for generating a first flag which is set when the first refresh request needs to be output; and
a second flag generation section for generating a second flag which is set when the second refresh request needs to be output,
wherein the control section outputs the first refresh request when the first flag is set and the detection section detects that the bus is free, and outputs the second refresh request when the second flag is set.

8. A memory refresh control apparatus according to claim 7, wherein the first flag is set when the first period passes, and the second flag is set when the first period passes while the first flag is set.

9. A memory refresh control apparatus according to claim 7, wherein the first flag is reset when the first refresh request is output, and the second flag is reset when the second refresh request is output.

*FIG.1*

Refresh count flag generator — 105
104
103
20
102
190
200
Refresh counter
107
101a
Refresh count overflow flag generator
101
Refresh count register
109
150
106
10
112
113
111
108
170
130
30
110
133
DRAM interface circuit
143
140
DRAM
Arbiter | Detection section
Bus interface circuit
151
CPU
152
121
100
131
134
141
160
132
142
120

EP 0 794 497 A2

11

FIG.2

START ⟶ 300

Refresh count flag
output 106 set to HIGH. ⟶ 301

Refresh
acknowledge output 109
HIGH or LOW? ⟶ 302

L

H

Refresh
count overflow flag output 108
HIGH or LOW? ⟶ 303

H

L

Refresh count flag
output 106 set to LOW. ⟶ 304

Refresh
count overflow output 104
HIGH or LOW? ⟶ 305

L

H

*FIG.3*

START — 400

401

Refresh count overflow flag
output 108 set to LOW.

402

Refresh
count overflow output 104
HIGH or LOW?

L

H

403

Refresh
count flag output 106
HIGH or LOW?

L

H

404

Refresh count overflow flag
output 108 set to HIGH.

405

Refresh
acknowledge output 109
HIGH or LOW?

L

H

13

## FIG. 4

```
                    ┌─────────────┐
                    │    START    │──── 500
                    └─────────────┘
                           │
         ┌─────────────────▼──────────── 501
         │      ┌──────────────────────────────┐
         │      │  Wait for refresh operation   │
         │      └──────────────────────────────┘
         │                 │
         │                 ▼                        502
         │         ╱────────────────────╲
         │   L    ╱      Refresh          ╲
         ◄───────◄  count flag output 106   ►
         │        ╲    HIGH or LOW?        ╱
         │         ╲────────────────────╱
         │                 │ H
         │                 ▼                   503
         │         ╱────────────────────╲       H
         │        ╱      Refresh          ╲──────────┐
         │       ◄ count overflow flag output 108    │
         │        ╲    HIGH or LOW?        ╱          │
         │         ╲────────────────────╱            │
         │                 │ L                        │
         │                 ▼             504          │
         │   H     ╱────────────────────╲             │
         ◄────────◄  Bus request signal 110  ►         │
         │         ╲    HIGH or LOW?     ╱             │
         │          ╲──────────────────╱              │      507
         │                 │ L    505                  ▼
         │                 ▼               ┌──────────────────────────┐
         │      ┌────────────────────────┐ │ Forcible refresh requested│
         │      │Non-bus-request refresh │ └──────────────────────────┘
         │      │      requested          │              │
         │      └────────────────────────┘              │
         │                 │◄─────────────────────────────┘
         │                 ▼          506
         │      ┌────────────────────────┐
         │      │Refresh operation execution│
         │      └────────────────────────┘
         │                 │
         └─────────────────┘
```

FIG.5

EP 0 794 497 A2